# EUROPÄISCHE PATENTANMELDUNG

(11) **EP 3 869 215 A1**
(43) Veröffentlichungstag der Anmeldung: **25.08.2021**
(21) Anmeldenummer: 21152731.2
(22) Anmeldetag: 21.01.2021
(51) Int. Cl.: G01R 33/032, G01R 33/12, G01R 33/00, H01F 6/04, F25D 19/00

(54) **SYSTEM ZUM BEREITSTELLEN EINES MAGNETFELDS FÜR EINE PROBE**

(30) Priorität: 20.02.2020 DE 102020104497
(71) Anmelder: attocube systems AG, 85540 Haar (DE)
(72) Erfinder: Duvinage, Christopher, 81379 München (DE); Schöning, Armin, 85652 Pliening (DE); Gragnaniello, Luca, 81825 München (DE)
(74) Vertreter: DTS Patent- und Rechtsanwälte Schnekenbühl und Partner mbB

(57) **Zusammenfassung**

Das System zum Bereitstellen eines Magnetfelds für eine Probe (8), umfasst eine erste Kontaktfläche (1) zum thermischen Kontaktieren der Probe (8) und eine zweite Kontaktfläche (2), die mit zumindest einem Magnetelement (4, 5,) in thermischem Kontakt steht.

## Beschreibung

Die Erfindung betrifft ein System zum Bereitstellen eines Magnetfelds für eine Probe sowie einen Tisch.

In vielen hochpräzisen und entsprechend hochempfindlichen optischen Experimenten wie beispielsweise denen der höchstauflösenden und mithin höchst sensiblen Super Resolution Optical Microscopy oder auch der Quantenoptik werden auf optischen Tischen bzw. auf einer ebenen tischähnlichen Konstruktion mit optischer Lochrasterplatte komplexe Messaufbauten aus einer Vielzahl von optischen Komponenten (wie Spiegel, Objektive, Kollimatoren, Blenden, Beleuchtungselemente) arrangiert. Die Messgenauigkeit wird durch Umgebungseinflüsse wie Vibrationen, thermische Effekte oder elektromagnetisches Rauschen begrenzt. Daher werden viele solcher Experimente unter am Ort einer zu vermessenden Probe möglichst vibrationsarmen und auch kryogenen Bedingungen durchgeführt.

Ferner ist es für die Untersuchung magnetooptischer Phänomene wünschenswert, zusätzlich zu den oben genannten Bedingungen auch gezielt ein Magnetfeld anlegen zu können. Hierfür wurden verschiedene Ansätze vorgeschlagen. Beispielsweise ist es bekannt, einen kryogenfreien HTS-Magneten (Hochtemperatur-Supraleiter, HTS) zu verwenden, um ein Magnetfeld im Bereich einer optischen Probe zu erzeugen. Dabei wird der Magnet um eine Bohrung herum angeordnet, in der eine Probe angeordnet und manipuliert werden kann. In dieser Bohrung herrscht Umgebungstemperatur. Der Magnet wird dabei von einem Kühlsystem getragen, um ihn mechanisch vom magnetooptischen Aufbau zu isolieren (Wolfus et al., "Compact HTS Cryogen-Free magnet for magneto-optics Research Setup", IEEE Transactions on Applied Superconductivity, Vol. 15, No. 2, Juni 2005).

Eine wichtige Herausforderung ist es dabei, möglichst einfachen und flexiblen Zugang zur untersuchten Probe sicherzustellen, um diese manipulieren und an ihr Messungen durchführen zu können.

Es ist die Aufgabe der Erfindung, ein System der eingangs genannten Art bereitzustellen, bei dem in flexibler und einfacher Weise vielfältig ausgestaltete magnetooptische Experimente mit höchster Auflösung durchgeführt werden können.

Diese Aufgabe wird durch ein System mit den Merkmalen des Anspruchs 1 gelöst. Vorteilhafte Ausgestaltungen und Weiterbildungen der Erfindung sind in den abhängigen Ansprüchen angegeben.

Das erfindungsgemäße System zum Bereitstellen eines Magnetfelds für eine Probe umfasst eine erste Kontaktfläche zum thermischen Kontaktieren der Probe und eine zweite Kontaktfläche, die mit zumindest einem Magnetelement in thermischem Kontakt steht. Ferner kann eine dritte Kontaktfläche im System vorgesehen sein, die wiederum mit zumindest einem weiteren Magnetelement in thermischem Kontakt steht. Des Weiteren ist prinzipiell die Anzahl der Kontaktflächen und der damit in thermischen Kontakt stehenden Magnetelemente nicht begrenzt.

Das Magnetelement ist dazu ausgebildet, ein Magnetfeld aktiv oder passiv zu erzeugen. Es kann insbesondere als elektromagnetisches Element ausgebildet sein oder ein solches umfassen, und es kann beispielsweise eine Spule umfassen; wenn nachfolgend eine Spule genannt ist, dann soll dies die Nutzung eines anders ausgebildeten Magnetelements oder elektromagnetischen Elements nicht einschränken, soweit im Kontext keine eindeutig auf eine Spule beschränkenden Merkmale angegeben sind. Ferner kann es sich bei dem Magnetelement um ein permanent-magnetisches (ferro-magnetisches) Material handeln.

Bei der Erfindung wird vorteilhafterweise eine thermische Entkoppelung der Magnetelemente und der Probe erreicht. Die Kühlung der Magnetelemente, insbesondere einer stromdurchflossenen Spule, erfolgt durch eine direkte oder indirekte thermische Kopplung an die zweite Kontaktfläche und kann daher gemäß deren Anforderungen geregelt werden, während zugleich die Temperatur der Probe durch die direkte oder indirekte thermische Kopplung an die erste Kontaktfläche eingestellt wird und daher gemäß den spezifischen Anforderungen des Experiments gewählt und gegebenenfalls verändert werden kann.

Eine dritte und alle prinzipiell möglichen weiteren Kontaktflächen und die im thermischen Kontakt damit befindlichen Magnetelemente sind insbesondere derartig ausgebildet, dass sie von der Probe sowie ebenfalls untereinander thermisch entkoppelt sind. Letzteres bietet die Möglichkeit verschiedenste Magnetelemente zur Erzeugung eines Magnetfeldes an der Probe zu kombinieren und das jeweils individuell erzeugte Magnetfeld zu einem absoluten Magnetfeld zu addieren und damit gegebenenfalls in Betrag zu verstärken und oder in Richtung zu verändern.

Bei einer Ausbildung der Erfindung ist das zumindest eine Magnetelement an einem Tieftemperatur-Schild befestigt, wobei der Tieftemperatur-Schild mit der zweiten Kontaktfläche in thermischem Kontakt steht. Insbesondere steht das Magnetelement also indirekt über den Tieftemperatur-Schild mit der zweiten Kontaktfläche in thermischen Kontakt. Das Magnetelement kann durch die thermische Kopplung mit dem Tieftemperatur-Schild vorteilhafterweise besonders einfach gekühlt werden. Für eine dritte Kontaktfläche sowie prinzipiell mögliche weitere Kontaktflächen gilt dasselbe. Es kann zudem sehr einfach nah an der Probe angeordnet werden, ohne dafür das der Probe bereitstehende Volumen zu stark verringern zu müssen. Zudem steht im Bereich des Tieftemperatur-Schildes ein relativ großer Bauraum für das Magnetelement zur Verfügung, sodass ein oder mehrere Magnetelemente unterschiedlich ausgebildet und sehr flexibel angeordnet werden können.

Dabei ist insbesondere vorgesehen, dass die erste und zweite Kontaktfläche, sowie gegebenenfalls weitere Kontaktflächen, sowie die Tieftemperatur-Schilde, die Magnetelemente und die Probe unter Bedingungen eines Hochvakuums angeordnet sind, insbesondere unter einer Vakuumglocke. Durch das Hochvakuum wird eine thermische Isolierung zwischen verschiedenen Objekten und Bereichen bei verschiedenen Temperaturen erreicht.

Das System kann beispielsweise so ausgebildet sein, dass die Probe in einem Probenvolumen und insbesondere an einem Probenhalter angeordnet ist, der mit der ersten Kontaktfläche thermisch gekoppelt sein kann. Das heißt, die thermische Kontaktierung der Probe kann direkt oder indirekt über weitere Elemente, etwa den Probenhalter, erfolgen. Der Tieftemperatur-Schild kann dann so ausgebildet sein, dass er über die Probe beziehungsweise den Probenhalter gestülpt wird und diesen zumindest seitlich, gegebenenfalls zu allen Seiten hin außer der Grundfläche mit der ersten und zweiten Kontaktfläche, umgibt. Bei Vorhandensein weiterer Kontaktflächen mit weiteren Magnetelementen wird ebenso verfahren. Eine ferner übergestülpte Vakuumglocke definiert einen Vakuumbereich, aus dem Luft abgepumpt werden kann. Durch die thermische Kontaktierung des Tieftemperatur-Schildes mit der zweiten Kontaktfläche kann der Schild auf eine bestimmte Temperatur gekühlt werden. Weitere Kontaktflächen mit weiteren Tieftemperatur-Schilden können ebenfalls gekühlt werden, typischerweise auf eine höhere Temperatur. Mit einem solchen Aufbau können beispielweise besonders niedrige Temperaturen im Bereich der Probe erzeugt werden, indem im Vakuum die Tieftemperaturschilde kaskadenartig auf tiefere Temperaturen als Raumtemperatur gekühlt werden. Bis hin zur Probe werden bei einem solchen Beispiel die Tieftemperatur-Schilde und damit die Kontaktflächen und Magnetelemente sukzessive auf tiefere Temperaturen gekühlt und der Probenhalter, beziehungsweise die Probe, auf eine weitere, noch geringere Temperatur.

Ferner kann vorgesehen sein, dass einzelne Tieftemperatur-Schilde vakuumdicht gegeneinander und gegenüber der Vakuumglocke ausgestaltet sind. Die Vakuumglocke und die Tieftemperatur-Schilde begrenzen dabei mindestens zwei verschiedene Volumen, in denen beispielsweise verschiedene Druckbedingungen hergestellt werden können und in denen gegebenenfalls verschiedene Gase und Gasgemische präsent sein können.

Die thermische Entkopplung wird insbesondere ferner dadurch erreicht, dass die erste und zweite Kontaktfläche sowie weitere prinzipiell mögliche Kontaktflächen voneinander entkoppelt sind, sodass verschiedene Temperaturen einstellbar sind. Eine thermische Kopplung zwischen Elementen, die mit der ersten, der zweiten, sowie prinzipiell möglichen weiteren Kontaktflächen thermisch gekoppelt sind, wird möglichst vermieden, etwa indem Materialien geringer Wärmeleitfähigkeit verwendet werden, um eine gegebenenfalls notwendige mechanische Kopplung auszubilden. Hierdurch wird ein resultierender Wärmefluss minimiert. Zu einer thermischen Entkopplung der Probe und der Tieftemperatur-Schilde auch untereinander trägt ferner das Vakuum bei.

Das System unterscheidet sich von bekannten Ansätzen unter anderem dadurch, dass zumindest ein Magnetelement, insbesondere zum Beaufschlagen der Probe mit einem Magnetfeld, weder außerhalb der Vakuumglocke bei Raumtemperatur und in großem Abstand zur Probe, noch innerhalb des Bereichs unmittelbar um die Probe herum und insbesondere nicht auf der gleichen Temperaturstufe wie die Probe und zumindest eine weitere, aber auch prinzipiell mögliche weitere Kontaktflächen, die mit zumindest je einem Magnetelement in thermischen Kontakt steht, angeordnet sind. Vor allem dadurch, dass das Magnetelement beziehungsweise die Magnetelemente nicht unmittelbar bei der Probe angeordnet und/oder mit der gleichen ersten Kontaktfläche thermisch kontaktiert sind, können die Temperaturen von Probe und Magnetelementen unterschiedlich geregelt werden, etwa um bei gleichbleibender Kühlung des Magnetelements die Messungen an der Probe in einem bestimmten veränderlichen Temperaturbereich durchzuführen. Insbesondere bleibt dabei das erzeugte Magnetfeld konstant und wird nicht durch Temperaturschwankungen beeinträchtigt. Das heißt, die thermische Entkoppelung der Probe und der Elemente kann zur Erweiterung des Spektrums der möglichen Experimente genutzt werden.

Dabei kann vorgesehen sein, dass mittels der ersten Kontaktfläche eine Kühlung der Probe beziehungsweise weitere mit der ersten Kontaktfläche in thermischem Kontakt stehender Objekte auf eine Temperatur unter 25 K, bevorzugt unter 15 K, weiter bevorzugt unter 10 K, weiter bevorzugt auf 4 K erzielbar ist. Ferner kann mittels der ersten Kontaktfläche eine Kühlung auf eine Temperatur von höchstens 1,5 K, bevorzugt höchstens 1 K, höchstens 100 mK oder höchstens 10 mK erreicht werden. Dabei ist die Erfindung im Allgemeinen nicht auf einen bestimmten Temperaturbereich beschränkt. Hierdurch können vorteilhafterweise thermische Störquellen für hochempfindliche Messungen weitgehend reduziert werden.

Ferner kann vorgesehen sein, dass die Temperatur, die durch eine thermische Kontaktierung der ersten Kontaktfläche erreicht wird, auf einen bestimmten Wert geregelt werden kann. Beispielsweise kann die Temperatur der ersten Kontaktfläche und damit insbesondere auch der damit thermisch kontaktierten Probe auf einen Wert von bis zu 100 K, bevorzugt bis zu 200 K, weiter bevorzugt bis zu 300 K, weiter bevorzugt bis zu 350 K einstellbar sein. Insbesondere kann dadurch die Temperatur der Probe eingestellt werden. Die erste Kontaktfläche ist insbesondere als kryogene Platte ausgebildet, mittels welcher die Temperatur, insbesondere innerhalb eines bestimmten Intervalls, eingestellt werden kann.

Dabei kann ferner vorgesehen sein, dass mittels der zweiten Kontaktfläche eine Kühlung des Tieftemperatur-Schildes und damit insbesondere auch des damit in thermischem Kontakt stehenden Magnetelements, auf eine Temperatur unter 150 K, bevorzugt unter 100 K, weiter bevorzugt unter 70 K, weiter bevorzugt auf 50 K erzielbar ist. Die zweite Kontaktfläche wird insbesondere von einer Kühleinheit so gekühlt, dass diese Temperatur des Magnetelements auch während ihres Betriebs erzielbar ist, insbesondere bei einem Wärmeeintrag durch elektrischen Strom, wenn ein Magnetfeld erzeugt wird. Diese Kühlung wird insbesondere auch dann erreicht, wenn die mit der ersten Kontaktfläche in thermischem Kontakt stehenden Elemente, insbesondere die Probe, Temperaturen in einem Bereich von bis zu 100 K, bevorzugt bis zu 200 K, weiter bevorzugt bis zu 300 K, weiter bevorzugt bis zu 350 K aufweist. Ferner können gegebenenfalls eine dritte sowie prinzipiell mögliche weitere Kontaktflächen ebenfalls auf die genannten Temperaturen oder beliebigen Zwischentemperaturen gekühlt werden, so dass die eingestellte Temperatur den Betriebsbedingungen des jeweiligen Magnetelementes entspricht. Beispielsweise können die erste und zweite Kontaktfläche thermisch mit einer Kältemaschine verbunden sein, die zwei Temperaturstufen bereitstellt. Die bei der ersten und zweiten Kontaktfläche erreichten Temperaturen entsprechen dann insbesondere den von der Kältemaschine bereitstellbaren Temperaturstufen. Bei der Erfindung können die erste und zweite Kontaktfläche insbesondere mittels eines sogenannten *"closed-cycle cryocoo*/*er"* beziehungsweise *"closed-cycle refrigerator"* (CCR) gekühlt werden. Eine dritte sowie prinzipiell mögliche weitere Kontaktflächen können ebenfalls über einen closed-cycle refrigerator mit einer dritten Temperaturstufe oder prinzipiell möglichen weiteren Temperaturstufen thermisch verbunden werden: Dabei bildet insbesondere das Gesamtsystem, umfassend die Vakuumglocke, die Tieftemperatur-Schilde sowie die erste und zweite, sowie gegebenenfalls die weiteren über einen CCR gekühlten Kontaktflächen, einen sogenannten *"closed-cycle cryostaf"* also einen Kryostaten. Dabei werden die Kontaktflächen per Wärmeleitung und insbesondere nicht mittels einer Flüssigkeit oder auf ähnliche Weise gekühlt.

Ferner kann ein closed-cycle refrigerator mit einer Vielzahl anderer Kühlungsmöglichkeiten kombiniert werden, die eine Vielzahl voneinander thermisch isolierter Kontaktflächen bietet. Bevorzugt werden hierbei Kombinationen eines CCR und eines Helium-4 Verdampfungskühlers, eines Helium Joule-Thomson Entspannungskühlers, eines Helium-3 / Helium-4 Verdünnungskühlers oder eines magnetischen Kühlers, der das Prinzip der adiabatischen Entmagnetisierungskühlung verwendet. Das thermische Funktionsprinzip, sowie die prinzipiell mögliche weitere Kombination der Kühler untereinander, ermöglicht per se eine Vielzahl an Kontaktflächen, die zur thermischen Kontaktierung von zumindest einem Magnetelement verwendet werden können.

Das Magnetelement kann etwa direkt an dem Tieftemperatur-Schild angebracht sein oder es kann indirekt daran befestigt sein, etwa mittels einer Befestigungsvorrichtung. Ferner können das Magnetelement und der Tieftemperatur-Schild als eine bauliche Einheit ausgebildet sein. Es kann ferner beispielsweise als elektromagnetisches Element ausgebildet sein oder ein solches umfassen. Es umfasst beispielsweise eine Spule und/oder einen Kern, wobei prinzipiell jedes der Magnetelemente einzeln oder in Kombination an dem Tieftemperatur-Schild befestigt sein kann. Insbesondere ist der Tieftemperatur-Schild so ausgebildet, dass das Magnetelement damit integriert ist, etwa als fest angebrachtes Magnetelement; in diesem Fall kann das System vorteilhafterweise besonders einfach ausgebildet sein, da der Tieftemperatur-Schild zum Zusammensetzen des Systems im Ganzen zusammen mit dem Magnetelement hantiert werden kann.

Das Magnetelement kann ferner lösbar oder fest mit dem Tieftemperatur-Schild verbunden sein. Es kann zudem in den Tieftemperatur-Schild integriert sein, etwa durch Einsetzen in eine Vertiefung oder Ausnehmung des Tieftemperatur-Schildes.

Bei einer weiteren Ausbildung ist das Magnetelement mit einer Steuereinheit gekoppelt, wobei die Steuereinheit dazu eingerichtet ist, das Magnetelement in Abhängigkeit von einem vorbestimmten Magnetfeld-Parameter mit einem Stromfluss so zu beaufschlagen, dass das bei der Probe bereitgestellte Magnetfeld den vorbestimmten Magnetfeld-Parameter aufweist. Insbesondere kann dabei eine Mehrzahl Magnetelemente vorgesehen sein, die von der Steuereinheit ansteuerbar sind. Dadurch kann die Probe vorteilhafterweise einem besonders genau definierten Magnetfeld ausgesetzt werden.

Der Magnetfeld-Parameter kann etwa eine Richtung, Stärke und/oder zeitliche Änderung eines Magnetfeldes betreffen, insbesondere an einer bestimmten Position, insbesondere an der Position der Probe beziehungsweise in einem definierten Probenvolumen. Das Magnetfeld kann als Vektor in einer, zwei oder drei Dimensionen sowie zeitlich veränderlich betrachtet werden. Durch die Ansteuerung insbesondere mehrerer Magnetelemente kann durch vektorielle Überlagerung von separat erzeugbaren und regelbaren Magnetfeldern ein Magnetfeld entsprechend einem bestimmten Magnetfeldvektor erzeugt werden, der das auf die Probe wirkende Magnetfeld definiert. Der vorbestimmte Magnetfeld-Parameter kann auf verschiedene Weise erfasst werden, etwa durch eine Eingabe eines Nutzers, oder er kann automatisch bestimmt werden, etwa beim Ausführen eines definierten Typs von Messungen.

Bei einer weiteren Ausbildung wird ferner ein vorbestimmter Temperaturwert für die Probe, das Magnetelement und/oder den Tieftemperatur-Schild eingestellt. Hierfür wird insbesondere durch die vorgenannte Steuereinheit oder eine weitere Steuereinheit ein Steuersignal erzeugt und an eine Einrichtung übertragen, die mit der ersten und/oder zweiten Kontaktfläche verbunden ist und über die jeweilige Kontaktfläche für eine Temperierung beziehungsweise Kühlung sorgt. Für eine dritte sowie prinzipiell weitere Kontaktflächen und damit in thermischen Kontakt stehende Magnetelemente kann ebenso verfahren werden.

Bei einer Ausführungsform des Systems ist insbesondere vorgesehen, dass eine Kühlung über die erste und/oder zweite Kontaktfläche mittels eines sogenannten *"closed-cycle"* Kühlers (CCR) erfolgt. Die Kühlung der Kontaktflächen erfolgt dabei ohne die Verwendung einer Kühlflüssigkeit, sondern durch Wärmeleitung.

Bei einer Weitebildung umfasst das System zumindest ein weiteres Magnetelement, das ebenfalls mit der zweiten Kontaktfläche in thermischen Kontakt steht und das paarweise mit dem Magnetelement angeordnet ist. Dabei sind die paarweise angeordneten Magnetelemente an gegenüberliegenden Seiten der Probe so angeordnet, dass sie eine gemeinsame Achse eines durch sie erzeugbaren Magnetfeldes aufweisen. Dadurch kann vorteilhafterweise besonders einfach ein homogenes und starkes Magnetfeld erzeugt werden.

Das weitere Magnetelement kann insbesondere mit dem Tieftemperatur-Schild in thermischem Kontakt stehen, wobei der thermische Kontakt zur zweiten Kontaktfläche insbesondere mittelbar über den Tieftemperatur-Schild hergestellt wird. Die Magnetelemente sind insbesondere an gegenüberliegenden Seiten des Tieftemperatur-Schildes angeordnet, sind daran befestigt und/oder stehen mit diesem in thermischem Kontakt.

Insbesondere umfassen die Magnetelemente, zwei Spulen, die beispielsweise konzentrisch oder in einer Helmholtz-Konfiguration angeordnet sein können. Insbesondere verlaufen dann die von den Spulen des Spulenpaars erzeugten Magnetfelder in die gleiche Richtung und verstärken einander, sodass zwischen den Spulen ein im Wesentlichen homogenes Magnetfeld erzeugt wird. Dabei kann insbesondere vorgesehen sein, dass die beiden paarweise angeordneten Magnetelemente Spulen umfassen, die äquidistant auf gegenüberliegenden Seiten der Probe angeordnet sind und im Wesentlichen auf einer Mantelfläche eines gedachten geraden Kreiszylinders liegen. Insbesondere verlaufen die - beispielsweise bei einer Helmholtz-Konfiguration oder einer konzentrischen Anordnung übereinanderliegenden - Spulenachsen durch die Probe.

Ferner kann es vorgesehen sein, dass beispielsweise zum Erzeugen eines großen Magnetfeldgradienten bei der Probe die Magnetfelder so erzeugt werden, dass sie in zueinander entgegengesetzte Richtungen verlaufen. Insbesondere kann ein Spulenpaar, das wie oben beschrieben angeordnet ist, so angesteuert werden, dass die durch den Stromfluss durch die Spulen erzeugten Magnetfelder einander entgegengesetzt sind; insbesondere wird dies in einer Anti-Helmholtz-Konfiguration erreicht.

Andere Konfigurationen der Magnetelemente und gegebenenfalls der davon umfassten Spulen sind ebenfalls von der Erfindung umfasst, insbesondere auch weitere Kombinationen von Spulendurchmessern, Ausrichtungen der Magnetelemente und zueinander verschobene Anordnungen.

Bei einer Ausbildung stehen zwei Paare von paarweise angeordneten Magnetelementen in thermischem Kontakt mit der zweiten Kontaktfläche und sind so angeordnet, dass die Achsen der mittels der jeweils paarweise zueinander angeordneten Magnetelemente erzeugbaren Magnetfelder senkrecht zueinander verlaufen. Es kann genau ein Paar vorgesehen sein oder zumindest zwei Paare, sodass auch drei oder mehr Paare von der Erfindung umfasst sind. Dadurch kann das erzeugte Magnetfeld vorteilhafterweise besonders einfach in Betrag und Richtung definiert und eingestellt werden.

Insbesondere stehen die beiden Paare von Magnetelementen mit dem Tieftemperatur-Schild in thermischem Kontakt und/oder sind an ihm befestigt.

Insbesondere werden die paarweise zueinander angeordneten Magnetelemente gemeinsam so angesteuert, dass ein homogenes Magnetfeld in einem Bereich zwischen den Elementen, insbesondere in dem Probenbereich, erzeugt wird. Ferner können jeweils genau zwei Paare von jeweils paarweise zueinander angeordneten Magnetelementen je eine magnetische Achse definieren, die insbesondere mit einer gemeinsamen Spulenachse zusammenfallen kann. Die magnetischen Achsen der beiden Paare können einander schneiden, insbesondere in einem rechten Winkel, und so eine Ebene aufspannen, innerhalb derer verschiedene vektoriell parametrisierbare Magnetfelder erzeugt werden können. Die aufgespannte Ebene kann insbesondere waagrecht, das heißt insbesondere senkrecht zu einer Achse des Tieftemperatur-Schildes, verlaufen.

Insbesondere ist zumindest ein weiteres Paar von paarweise zueinander angeordneten Magnetelementen vorgesehen, wobei eine Achse eines mittels des weiteren Paars erzeugbaren Magnetfeldes zu den beiden Achsen der beiden Paare von Magnetelementen verläuft. Das heißt, die durch das weitere Paar definierte Achse kann senkrecht zu der Ebene verlaufen, die durch die magnetischen Achsen zweier Paare von Magnetelementen aufgespannt wird. Insbesondere können die genannten Achsen als x-, y- und z-Achse verstanden werden, die insbesondere senkrecht zueinander angeordnet sind und die Achsen eines als kartesisches Koordinatensystem begriffenen dreidimensionalen Koordinatensystems bilden. Insbesondere ist eine waagrechte x-y-Ebene definiert, die durch senkrecht zueinander verlaufende magnetische Achsen von zwei Paaren von Magnetelementen aufgespannt wird. Ferner ist eine senkrechte z-Achse definiert, die entlang einer magnetischen Achse eines weiteren Paares Magnetelemente verläuft. "Senkrecht" und "waagrecht" sind dabei relativ zum Schwerefeld der Erde definiert. Ferner kann "waagrecht" als parallel zu einer Tischoberfläche definiert sein, an der das System angeordnet ist. Ferner kann "senkrecht" als parallel zu einer Längsachse eines Probenhalters und/oder des Tieftemperatur-Schildes definiert sein.

Bei einer weiteren Ausbildung steht ferner zumindest ein weiteres Magnetelement, dem insbesondere eine senkrecht verlaufende magnetische Achse zugeordnet sein kann, in thermischem Kontakt zu der ersten Kontaktfläche. Das weitere Magnetelement kann dadurch vorteilhafterweise gemeinsam mit der Probe gekühlt werden und insbesondere eine besonders niedrige Temperatur erreichen.

Bei dem System ist in diesem Fall zusätzlich zu dem Magnetelement, das mit dem Tieftemperatur-Schild thermisch gekoppelt ist, ein weiteres, davon thermisch entkoppeltes Magnetelement vorgesehen. Für dieses kann durch die Kühlung im thermischen Kontakt mit der ersten Kontaktfläche beispielsweise eine Temperatur von unter 10 K, bevorzugt von etwa 4 K oder niedriger, etwa höchstens 1,5 K, höchstens 1 K, höchstens 100 mK oder höchstens 10 mK, erreicht werden. Dabei ist die Erfindung im Allgemeinen nicht auf einen bestimmten Temperaturbereich beschränkt.

Insbesondere kann das weitere Magnetelement so ausgebildet und angeordnet sein, dass es ein Magnetfeld erzeugt, das senkrecht zu den Magnetfeldern steht, die durch jeweils paarweise zueinander angeordnete Magnetelemente erzeugbar sind. Dadurch kann vorteilhafterweise ein vorgegebener Magnetfeldvektor mit Betrag und Richtung dargestellt werden.

Insbesondere kann ein weiteres Paar von Magnetelementen, etwa ein Spulenpaar, vorgesehen sein, deren gemeinsame Achse senkrecht zu den Achsen einer oder zweier Spulenpaare in thermischer Verbindung mit dem Tieftemperatur-Schild stehen. Beispielsweise ist durch das Magnetelement in Kontakt mit der ersten Kontaktfläche ein Magnetfeld entlang einer z-Achse erzeugbar, wogegen Magnetfelder in einer x-y-Ebene durch weitere Magnetelemente erzeugt werden, die insbesondere mit dem Tieftemperatur-Schild in thermischem Kontakt stehen.

Die thermische Kontaktierung des Magnetelements erlaubt eine Kühlung bis auf sehr niedrige Temperaturen. Wenn durch den thermischen Kontakt mit der ersten Kontaktfläche eine entsprechend niedrige Temperatur erreicht wird, dann kann hierfür ein Supraleiter verwendet werden, dessen Sprungtemperatur eine Kühlung auf beispielsweise unter 40 K erfordert.

Bei einer Weitebildung umfasst das Magnetelement ein supraleitendes Material, insbesondere einen Hochtemperatursupraleiter. Insbesondere ist das supraleitende Material so gebildet, dass es eine Sprungtemperatur oberhalb der Betriebstemperatur des Tieftemperatur-Schildes aufweist; in diesem Fall wird der supraleitende Zustand erreicht, wenn der Tieftemperatur-Schild auf seine Betriebstemperatur gekühlt wird. Dadurch kann vorteilhafterweise ein hohes Magnetfeld erzeugt werden.

Bei einem Supraleiter, der insbesondere durch Abkühlen unter seine Sprungtemperatur in einen supraleitenden Zustand gebracht wurde, führen auch sehr hohe Ströme, etwa in einer supraleitenden Spule, nicht zu einer starken Wärmeentwicklung durch ohmsches Heizen, wie dies durch einen elektrischen Widerstand bedingt wäre. Das Magnetelement, etwa eine Spule, kann daher kleiner und insbesondere mit einem geringeren Leitungsquerschnitt relativ zur Stromstärke ausgelegt werden. Ferner entfällt ein zusätzlicher Kühlungsbedarf für die Spule, um ungewünschten zusätzlichen Wärmeeintrag zu minimieren und Schäden durch die strombedingte Wärmeentwicklung zu vermeiden.

Zum Beispiel kann ein Tieftemperatur-Supraleiter (*low temperature superconductor*, LTS) eingesetzt werden, etwa ein Niob-Titan-Supraleiter. Als Supraleiter können beispielsweise NbTi, Nb₃Sn, Nb₃Al, Nb₃Ge oder MgB₂ verwendet werden, deren Sprungtemperaturen bei etwa 9,25 K, 18,3 K, 18 K, 23,2 K beziehungsweise 39 K liegen. Unterhalb der Sprungtemperatur wird der supraleitende Zustand des jeweiligen Materials erreicht. Dabei wird MgB₂ üblicherweise trotz seines hohen Sprungtemperatur zu den LTS gezählt. Von einem Hochtemperatur-Supraleiter wird hingegen typischerweise gesprochen, wenn die Sprungtemperatur des Materials bei etwa 30 K oder höher liegt, etwa über 70 K oder 90 K bis 140 K. Insbesondere kann ein Hochtemperatursupraleiter der zweiten Generation vorgesehen sein.

Ferner kann bei einer Ausbildung ein Halbleitermaterial verwendet werden. Hierbei gibt es insbesondere sogenannte Weyl- und Dirac-Halbmetalle, die bei der Erfindung genutzt werden können. Beispiele für Materialien aus der Familie der Weyl-Halbmetalle sind NbP, TaP, NbAs, and TaAs. Diese werden bereits vielfältig verwendet, zum Beispiel als Photoelemente, Thermoelektrika oder in anderen Kontexten.

Insbesondere ist mittels der zweiten Kontaktfläche eine Kühlung des Magnetelements auf eine Temperatur unterhalb der Sprungtemperatur erzielbar, das heißt, das Element kann so gekühlt werden, dass das Material supraleitende Eigenschaften annimmt.

Bei einer Ausbildung umfasst das Magnetelement ein Metall oder Halbmetall. Dadurch wird vorteilhafterweise die thermische Kontaktierung zu dem Tieftemperatur-Schild und dadurch mittelbar zu der zweiten Kontaktfläche genutzt, um die bei hohem Strom entstehende Wärme abzuführen und dadurch ein hohes Magnetfeld mit konventionellen Elektromagneten erzeugen zu können. Insbesondere wird hierzu die hohe Kühlleistung bekannter Kühlvorrichtungen genutzt.

Insbesondere ist ein Material vorgesehen, das einen sehr geringen spezifischen Widerstand und eine sehr hohe thermische Leitfähigkeit aufweist. Es kann sich dabei um ein Metall wie beispielsweise Kupfer, Aluminium, Platin oder Silber handeln. Allerdings sind auch beispielsweise Weyl- und Dirac-Halbmetalle bekannt, die für eine solche Anwendung infrage kommen können.

Ein solches Magnetelement kann zwar typischerweise nur kleinere Magnetfelder erzeugen als ein Supraleiter, diese können jedoch für eine Reihe von Anwendungen bereits ausreichen. Ferner können solche Magnetelemente wesentlich kosteneffizienter herzustellen sein.

Ferner kann eine Kombination von Magnetelementen verwendet werden, die teilweise supraleitende Elemente und teilweise herkömmliche, nicht supraleitende Elemente umfassen. Ferner kann bevorzugt eine Kombination von verschiedenen supraleitenden Elementen, etwa einem LTS mit einem HTS auf unterschiedlichen Kontaktflächen realisiert werden.

Bei einer weiteren Ausbildung umfasst der Tieftemperatur-Schild eine umlaufende Wand, welche die Probe umgibt und welche mit einer optischen Zugangsöffnung versehen sein kann. Die Wand kann insbesondere zylindrisch ausgebildet sein. Sie kann ferner einen Querschnitt einer anderen Geometrie aufweisen, etwa einen rechteckigen oder quadratischen Querschnitt. Dadurch kann vorteilhafterweise ein abschirmender Effekt durch den Tieftemperatur-Schild erreicht werden, insbesondere gegenüber Wärmestrahlung eines weiteren Tieftemperatur-Schildes, der bei einer höheren Temperatur betrieben wird oder einer das System umgebenden Raumtemperatur.

Ein optischer Zugang zum Inneren des Systems, insbesondere in den Bereich der Probe, kann auf verschiedene Weisen erfolgen. Es kann ein Objektiv oder eine andere Optik mit Linsen vorgesehen sein, um Signale ein- und/oder auskoppeln zu können. Beispielsweise können so optische Signale und Felder zur Probe gebracht oder von der Probe ausgehend detektiert werden. Alternativ oder zusätzlich können verschiedene optische Zugänge durch Freistrahl oder faserbasiert realisiert werden.

Bei einer Weiterbildung umfasst das System ein Modul zur thermischen Kontaktierung mit der ersten Kontaktfläche. Insbesondere ist das Modul dazu eingerichtet, einen Probenträger aufzunehmen, etwa indem es über diesen gestülpt oder gesetzt wird. Es kann ferner fest mit dem Probenträger verbunden sein, etwa indem dieser in dem Modul integriert ist.

Dieses Modul ist mit der ersten Kontaktfläche thermisch gekoppelt. Wenn es sich dabei um eine Stufe mit besonders niedriger Temperatur handelt, etwa eine 4 K-Stufe, so wird das Modul entsprechend gekühlt. Wenn nachfolgend von einer 4 K-Stufe die Rede ist, dann soll dies nicht als Beschränkung auf eine bestimmte Temperatur verstanden werden; insbesondere kann bei dem Modul eine geringere Temperatur von beispielweise höchstens 1,5 K, bevorzugt höchstens 1 K, höchstens 100 mK oder höchstens 10 mK erreicht werden. Das Modul kann ferner Magnetelemente umfassen, etwa einen supraleitenden Magneten, dessen Sprungtemperatur so gewählt ist, dass sie bei der Anordnung in dem System unterschritten wird. Ferner kann vorgesehen sein, dass die Temperatur des Moduls und damit auch der Probe veränderlich ist, etwa um Eigenschaften der Probe bei verschiedenen Temperaturen zu beobachten.

Bei einer weiteren Ausbildung des Systems kann der Tieftemperatur-Schild als ein Modul ausgebildet sein, das separat von anderen Elementen des Systems, etwa dem Modul mit einem Probenträger, ausgebildet und innerhalb des Systems von diesem thermisch isoliert ist. Dieses weitere Modul steht insbesondere in thermischem Kontakt mit der zweiten Kontaktfläche.

Das Modul mit dem Tieftemperatur-Schild kann etwa ein Objektiv-Element umfassen, das hierdurch ebenfalls direkt oder indirekt thermisch mit der ersten Kontaktfläche gekoppelt ist. Das Objektiv-Element ist insbesondere dazu ausgebildet und so angeordnet, dass es einen optischen Zugang zu der Probe erlaubt, etwa indem optische Signale durch das Objektiv-Element zu der Probe und/oder von der Probe zu einem Messsensor übertragbar sind.

Die Integration des Objektiv-Elements in das Modul erlaubt eine Anordnung besonders dicht an der Probe; hierdurch ist auch eine besonders große Auflösung wegen einer hohen Numerischen Apertur erreichbar. Ferner hat eine Anordnung dicht an der Probe den Vorteil, dass eine besonders hohe Sammeleffizienz erreicht wird, das heißt, es können besonders viele Photonen von der Probe zum Objektiv-Element gelangen und detektiert werden; dies ist insbesondere bei der Detektion schwacher Signale, etwa von Einzelphotonenquellen, von Bedeutung. Bei bekannten Systemen besteht eine Schwierigkeit oft darin, mit einem Objektiv von außen einen geringen Abstand zur Probe zu erreichen, die in einer Vakuumkammer angeordnet und gegebenenfalls von weiteren Elementen, etwa Elektromagneten, umgeben ist. Indem das Objektiv-Element in dem Modul angeordnet ist, kann das Objektiv in der Vakuumkammer angeordnet und zusammen mit gegebenenfalls notwendigen weiteren Einrichtungen untergebracht sein.

Alternativ oder zusätzlich zu einem Objektiv-Element können andere Einrichtungen vorhanden sein, die einen optischen Zugang zum Zuführen elektromagnetischer Strahlung zur Probe und/oder zur Detektion von elektromagnetischer Strahlung von der Probe erlauben. Beispielsweise können eine Freistrahloptik oder ein faserbasierter optischer Zugang vorgesehen sein.

Bei einer Ausbildung der Erfindung erfolgt mittels der zweiten Kontaktfläche eine Kühlung, wobei eine höhere Temperaturstufe als bei der ersten Kontaktfläche erreichbar ist. Insbesondere kann vorgesehen sein, dass die erste Kontaktfläche so eingerichtet ist, dass durch sie eine stärkere Kühlung als bei der zweiten Kontaktfläche erreichbar ist. Beispielsweise ist das weitere Modul als 40 K- oder 50 K-Stufe ausgebildet, die ein als 4 K-Stufe ausgebildetes Modul umgibt und einerseits gegenüber der umgebenden Raumtemperatur abschirmt und andererseits thermisch entkoppelt ist. Auch die Bezeichnung als 40 K- oder 50 K-Stufe soll nicht einschränkend verstanden werden; vielmehr können verschiedene Temperaturstufen erreicht werden. Das heißt, die Temperaturen der verschiedenen Module oder Stufen können im Wesentlichen oder zumindest innerhalb bestimmter Temperaturbereiche unabhängig voneinander eingestellt und variiert werden. Beispielsweise kann ein supraleitendes Magnetelement in thermischem Kontakt mit dem Tieftemperatur-Schild dauerhaft bei einer Temperatur unterhalb der Sprungtemperatur gehalten werden, während die Temperatur des innerhalb des Tieftemperatur-Schildes angeordneten Moduls, insbesondere eines Probenträgers beziehungsweise einer Probe, variiert wird.

Das System kann ferner so ausgebildet sein, dass es ganz oder teilweise als fest oder lösbar zusammengesetztes Element ausgebildet ist; hierdurch wird vorteilhafterweise ein hoher Integrationsgrad erreicht. Insbesondere kann vorgesehen sein, dass ein zusammengesetztes Element eine Vakuumglocke, die im Betrieb der Umgebung zugewandt ist und beispielsweise die Umgebungstemperatur aufweist, und der Tieftemperatur-Schild miteinander verbunden sind. Das System kann dann erhalten werden, indem dieses zusammengesetzte Element beispielsweise über einen Probenhalter gesetzt wird. Ferner kann ein zusammengesetztes Element die Komponenten des Systems umfassen, die innerhalb der Vakuumglocke angeordnet sind. Beispielsweise wird ein solches zusammengesetztes Element zum Betrieb so auf die erste und zweite Kontaktfläche gesetzt, dass die entsprechenden Komponenten mit der richtigen Kontaktfläche in thermischem Kontakt stehen.

Der erfindungsgemäße Tisch umfasst ein gemäß der obenstehenden Beschreibung ausgebildetes System, wobei die erste und zweite Kontaktfläche im Bereich einer Tischplatte des Tischs ausgebildet sind. Dadurch kann vorteilhafterweise ein besonders hoher Integrationsgrad des Systems mit weiteren Komponenten eines magnetooptischen Experiments erreicht werden. Hierdurch wird ferner eine besonders einfache und sichere Bedienung ermöglicht, wobei ferner Schwingungen und andere Störungen aus der Umwelt vermieden werden können.

Die Integration in den Tisch erfolgt insbesondere so, dass Objekte auf dem Tisch, etwa Teile einer Versuchsanordnung, relativ zu den Kontaktflächen in Position und Ausrichtung justiert und eingestellt werden können.

Der Tisch ist insbesondere als optischer Tisch ausgebildet. Er kann mit zumindest einer Dämpfungsvorrichtung versehen sein, die eine Übertragung von Schwingungen in der Umgebung des Tisches über die Tischbeine auf die Tischplatte und/oder auf der Tischplatte angeordnete Objekte dämpft. Typischerweise umfasst die Tischplatte eines optischen Tischs Befestigungspunkte für bei einem Experiment verwendete Elemente das System kann an einem oder mehreren solchen Befestigungspunkten fixiert werden.

Ferner kann in dem Tisch, insbesondere in der Tischplatte, eine Ausnehmung ausgebildet sein, die welche das System eingesetzt wird.

Bei einer Weiterbildung der Erfindung ist das System zumindest teilweise in den Tisch integriert. Beispielsweise kann die Tischplatte des insbesondere optischen Tischs eine Ausnehmung aufweisen, in der die erste und zweite Kontaktfläche sowie gegebenfalls eine oder mehrere weitere Kontaktflächen angeordnet sind. Die weiteren Elemente des Systems, insbesondere eine Vakuumglocke, der Tieftemperatur-Schild und der Probenhalter, sind entsprechendem mit der ersten oder zweiten Kontaktfläche thermisch kontaktiert und insbesondere lösbar an der Tischplatte befestigt, etwa mittels Schrauben.

Bei einem Verfahren zum Betreiben des erfindungsgemäßen Systems zum Bereitstellen eines Magnetfelds für eine Probe wird eine erste Kontaktfläche, die mit der Probe in thermischem Kontakt steht, auf eine erste Temperatur gekühlt. Eine zweite Kontaktfläche, die mit einem Tieftemperatur-Schild in thermischem Kontakt steht, wird auf eine zweite Temperatur gekühlt. Insbesondere liegen die erste und zweite Temperatur unter einer Umgebungstemperatur; beispielsweise liegt die erste Temperatur bei unter 10 K, bevorzugt 4 K; beispielsweise liegt die zweite Temperatur bei unter 70 K, bevorzugt bei 50 K oder 40 K. Dabei steht der Tieftemperatur-Schild mit einem Magnetelement in thermischem Kontakt. Insbesondere wird das Magnetelement von einer Steuereinheit so angesteuert, dass ein Magnetfeld mit einem vorgegebenen magnetischen Parameter im Bereich der Probe erzeugt wird.

Das Verfahren dient insbesondere dem Betrieb des oben erläuterten erfindungsgemäßen Systems und weist daher die gleichen Vorteile auf.

Nachfolgend wird die Erfindung anhand der anliegenden Zeichnungen näher erläutert. Es zeigen:
- **Figur 1**: eine Seitenansicht eines ersten Ausführungsbeispiels des erfindungsgemäßen Systems; und
- **Figur 2**: eine Schnittdarstellung des Ausführungsbeispiels des erfindungsgemäßen Systems.

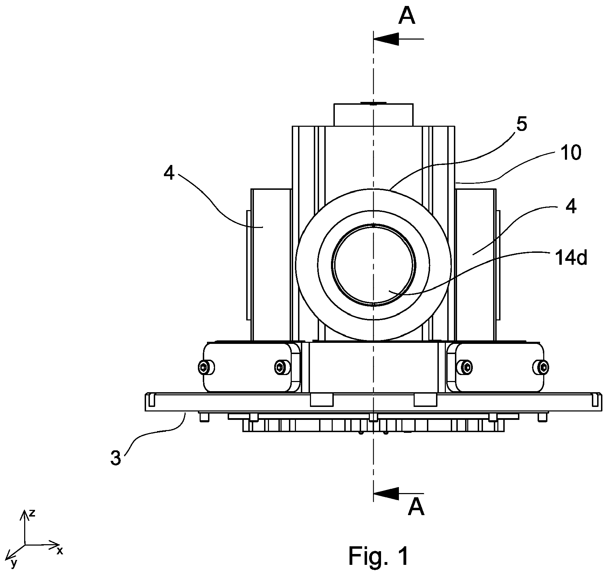

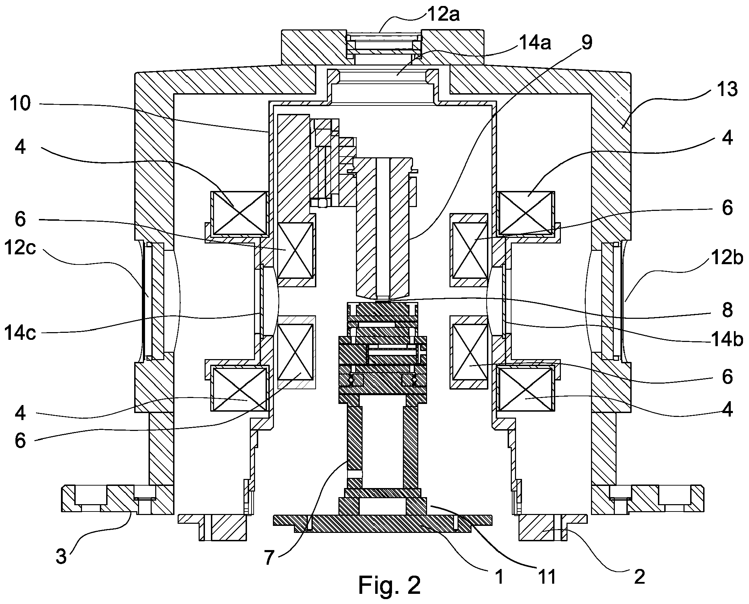

Mit Bezug zu den **Figuren 1** und **2** wird ein Ausführungsbeispiel des erfindungsgemäßen Systems erläutert.

Das Ausführungsbeispiel des Systems ist dreistufig aufgebaut, was in der in Figur 2 gezeigten Schnittzeichnung durch verschiedene Schraffuren zum Ausdruck kommt: Eine äußere Stufe, die nachfolgend als "300 K-Stufe" 13 bezeichnet wird, ist als ein Modul 13 ausgebildet und hat etwa die aktuelle Umgebungstemperatur; eine typische Raumtemperatur bewegt sich beispielsweise in einem Bereich um 300 K, ist allerdings nicht darauf beschränkt.

Die 300 K-Stufe 13 ist nach Art einer Glocke ausgebildet, die über weitere Elemente gestülpt werden und an einer Basisfläche abgedichtet werden kann. Im Kontext der Anmeldung wird als "Glocke" eine Struktur verstanden, wie sie je nach Kontext auch als "Haube" oder "Kammer" bezeichnet wird. Dies ermöglicht das Abpumpen von Luft innerhalb der 300 K-Stufe 13 zum Herstellen eines Hochvakuums. Entsprechende Anschlüsse für eine Vakuumpumpe sind beispielsweise im Bodenbereich des Systems vorgesehen und werden hier nicht näher erläutert. Durch das Vakuum innerhalb der 300 K-Stufe 13 wird eine thermische Isolierung aller Elemente in dem Innenraum erreicht, sodass es zum Übertrag thermischer Energie im Wesentlichen nur durch Wärmestrahlung und/oder direkten mechanischen Kontakt von Elementen kommt. Eine Basis 3 der 300 K-Stufe 13 kann mit einer Bodenfläche, etwa auf einer Tischplatte eines optischen Tischs, verschraubt oder anderweitig gesichert werden.

Ferner ist vorgesehen, dass die 300 K-Stufe 13 optische Zugänge 12a, 12b, 12c aufweist, die etwa als verglaste Öffnungen ausgebildet und gegen das Eindringen von Luft in das Vakuum sind. Weitere optische Zugänge sind ebenfalls vorgesehen, die in der Darstellung nicht sichtbar sind. Bei weiteren Ausführungsbeispielen können optische Zugänge in verschiedener Anzahl, Art und Form vorgesehen sein. Durch die optischen Zugänge 12a, 12b, 12c kann List in den Innenraum der 300 K-Stufe 13 geleitet werden, etwa durch Einkoppeln eines Laserstrahls, und/oder es kann Licht von innen nach außen gelangen, sodass beispielsweise optische Messungen von außen vorgenommen werden können.

Innerhalb der 300 K-Stufe 13 ist ein weiteres Modul 10 vorgesehen, das nachfolgend als "50 K-Stufe" 10 bezeichnet wird, ohne es damit auf eine bestimmte Temperatur einzuschränken. Die 50 K-Stufe 10 dient bei dem Ausführungsbeispiel als Tieftemperatur-Schild 10, um innerhalb des Innenraums der 300 K-Stufe 13 stufenweise Bereiche niedrigerer Temperatur definieren zu können. Indem der Tieftemperatur-Schild auf eine wesentlich niedrigere Temperatur als die Umgebungstemperatur gekühlt wird, beispielsweise auf 50 K, wobei die Erfindung aber nicht auf diesen Wert beschränkt ist, kann der von dem Tieftemperatur-Schild 10 umschlossene Bereich gegenüber der Außentemperatur abgeschirmt und leichter auf eine noch niedrigere Temperatur gekühlt werden. Beispielsweise kann so ein von dem Tieftemperatur-Schild 10 umschlossenes, weiteres Modul 11 als "4 K-Stufe" 11 ausgebildet sein und auf eine entsprechende Temperatur gekühlt werden, etwa auf 4 K. Das Ausführungsbeispiel beschränkt die Erfindung allerdings nicht auf diesen Wert; beispielsweise können in anderen Ausführungsbeispielen bei der "4 K-Stufe" 11 auch Temperaturen von höchstens 1,5 K, bevorzugt höchstens 1 K, höchstens 100 mK oder höchstens 10 mK erreicht werden.

Die Kühlung der 50 K-Stufe 10, im vorliegenden Fall auf etwa 50 K, erfolgt durch Kontakt mit einer zweiten Kontaktfläche 2 im Bodenbereich. Die Kontaktfläche 2 ist mit einer nicht dargestellten Kältemaschine, die bei dem Ausführungsbeispiel als *"closed cycle refrigerator"* (CCR) ausgebildet ist, so verbunden, dass durch den thermischen Kontakt mit der Fläche Wärmeenergie entzogen wird, bis eine definierte Temperatur erreicht wird.

Bei dem Ausführungsbeispiel ist vorgesehen, dass die 50 K-Stufe 10 optische Zugänge 14a, 14b, 14c umfasst, die so angeordnet sind, dass sie mit den optischen Zugängen 12a, 12b, 12c der 300 K-Stufe 13 so entlang einer optischen Achse liegen, dass die oben beschriebenen Zugangsmöglichkeiten etwa für optische Experimente aus der Umgebung des Systems bis in den von der 50 K-Stufe 10 umschlossenen Raum ermöglicht werden. Auch hier können, wie oben bereits für die 300 K-Stufe 13 beschrieben, weitere optische Zugänge vorgesehen sein, die bei dem hier gezeigten Ausführungsbeispiel nicht dargestellt sind.

Innerhalb der 50 K-Stufe 10 ist bei dem Ausführungsbeispiel ein weiteres Modul 11 vorgesehen, das nachfolgend als "4 K-Stufe" 11 bezeichnet wird. Die 4 K-Stufe 11 steht mit einer ersten Kontaktfläche 1 in thermischem Kontakt und wird durch diese gekühlt, wobei die Kühlung im Wesentlichen analog zur oben beschriebenen Kühlung der 50 K-Stufe 10 erfolgt. Allerdings kann hier eine deutlich niedrigere Temperatur erreicht werden, etwa weniger als 10 K, weniger als 8 K oder 4 K.

Die 4 K-Stufe 11 umfasst bei dem Ausführungsbeispiel einen Probenhalter 7, auf dem eine Probe 8 angeordnet ist und der (hier nicht näher erläuterte) Aktoren zum Manipulieren der Probe 8 aufweist, insbesondere zum Positionieren der Probe 8. Der Probenhalter 7 ist so ausgebildet, dass er die darin gehaltene Probe 8 in einem Bereich so positionieren kann, dass durch die optischen Zugänge 12a, 12b, 12c, 14a, 14b, 14c optische Einflüsse eingekoppelt und/oder optische Signale ausgekoppelt werden können. Der Probenhalter 7 wird bei dem Ausführungsbeispiel auf die gleiche Temperatur wir die 4 K-Stufe 11 gekühlt, sodass auch die Probe 8 entsprechend gekühlt wird.

Bei dem Ausführungsbeispiel ist ferner vorgesehen, dass in thermischem Kontakt zu der 50 K-Stufe 10 ein Objektiv-Element 9 so angeordnet ist, dass es in geringem Abstand zu der Probe 8 auf diese gerichtet ist. Durch die Anordnung im Kontakt mit der 50 K-Stufe 10 ergibt sich der besondere Vorteil, dass das Objektiv-Element 9 thermisch von der Probe 8 entkoppelt ist. Das heißt, auch bei einer Veränderung der Temperatur der Probe 8, wenn etwa eine Variation der Temperatur zu den Bedingungen eines Experimentes gehört, kommt es nicht zu temperaturbedingten Veränderungen beispielsweise der Fokussierung oder anderen Drift-Phänomenen.

Das Objektiv-Element 9 ist bei dem Ausführungsbeispiel über zumindest einen Aktor manipulierbar gelagert, etwa um thermischen Drift und eine dadurch bedingt Defokussierung zu vermeiden oder um das System für verschiedene Proben und/oder Versuchsanordnungen anzupassen. Dabei kann die Position des Objektiv-Elements 9 insbesondere in senkrechte z-Richtung eingestellt werden; insbesondere wird ein Abstand des Objektiv-Elements 9 zur Probe 8 eingestellt. Allerdings kann bei weiteren Ausführungsbeispielen alternativ oder zusätzlich vorgesehen sein, dass die Position des Objektiv-Elements 9 anderweitig einstellbar ist, insbesondere relativ zur Probe 8, beispielsweise in der waagrechten x-y-Ebene oder in einer bestimmten Richtung. Ferner kann die Lage des Objektiv-Elements 9 in anderer Weise veränderbar sein, definiert etwa durch eine Richtung im Raum beziehungsweise durch Winkel relativ zu den Achsen des Systems. Je nach Ausbildung des Systems kann somit die Anordnung des Objektiv-Elements 9 beispielsweise in drei Raumdimensionen frei oder mit bestimmten Einschränkungen manipulierbar sein.

Bei dem Ausführungsbeispiel ist das Objektiv-Element 9 senkrecht von oben auf die Probe 8 gerichtet, allerdings sind andere Anordnungen, insbesondere mit mehreren Objektiv-Elementen 9, denkbar. Das Objektiv-Element 9 ist zum Betrieb im Bereich der Temperatur der 50 K-Stufe 10 geeignet. Durch die Anordnung innerhalb des Tieftemperatur-Schildes 10 kann das Objektiv-Element 9 vorteilhafterweise sehr dicht an der Probe 8 positioniert werden, was wiederum eine hohe Numerische Apertur und entsprechend hochauflösende Messungen erlaubt. Ferner wird eine besonders hohe Sammeleffizienz erlaubt, sodass schwache optische Signale, etwa von Einzelphotonenquellen, detektiert und gemessen werden können. Das Objektiv-Element 9 ist so angeordnet, dass seine der Probe 8 abgewandte Seite einem optischen Zugang 14a der 50 K-Stufe 10 sowie, in der weiteren Verlängerung einem optischen Zugang 12a der 300 K-Stufe 13 zugewandt ist. Durch diese optischen Zugänge 14a, 12a können optische Signale zur Probe 8 in das Objektiv-Element 9 eingekoppelt und auf die Probe 8 gerichtet werden. Umgekehrt können optische Signale von der Probe 8 durch das Objektiv-Element 9 zu den optischen Zugängen 14a, 12a gelangen und dort beispielsweise detektiert werden.

Bei weiteren Ausführungsbeispielen kann das Objektiv-Element 9 in thermischem Kontakt zu der 4 K-Stufe 11 stehen, in das Modul der 4 K-Stufe 11 integriert sein oder auf andere Weise angeordnet und/oder thermisch kontaktiert sein.

Bei weiteren Ausführungsbeispielen ist kein Objektiv-Element 9 vorgesehen oder es ist auf andere Weisen ausgebildet, etwa ohne eine Linsenoptik. Es kann beispielsweise ein faserbasierter optischer Zugang vorgesehen sein oder es kann eine Optik für den freien Zugang von Lichtstrahlen zur Probe beziehungsweise zur direkten Detektion von Lichtstrahlen von der Probe vorgesehen sein.

Bei dem Ausführungsbeispiel ist vorgesehen, dass Magnetelemente 4, 5, 6, die bei diesem Ausführungsbeispiel als elektromagnetische Elemente 4, 5, 6 mit Spulen 4, 5, 6 ausgebildet sind, Magnetfelder entlang dreier aufeinander senkrecht stehender Achsen erzeugt werden können. Bei weiteren Ausführungsbeispielen ist zumindest eines der Magnetelemente 4, 5, 6 nicht elektromagnetisch ausgebildet, etwa durch Verwendung eines Permanentmagneten oder auf andere Weise.

Die Magnetfelder werden bei dem Ausführungsbeispiel mittels der jeweils paarweise und konzentrisch zueinander angeordneten Spulen 4, 5, 6 so erzeugt, dass sie im Bereich der Probe 8 im Wesentlichen homogen ausgebildet sind und als überlagerte Komponenten gebildet werden. Insbesondere können Paare von Spulen 4, 5, 6 in einer Helmholtz-Konfiguration oder in einer ähnlichen Konfiguration ausgebildet und angeordnet sein. Durch eine koordinierte Ansteuerung des Stroms, der durch die Spulen 4, 5, 6 geleitet wird, können Magnetfeldvektoren mit einem großen Umfang von Parametern im Bereich der Probe 8 erzeugt werden. Die hier wesentlichen Parameter umfassen etwa eine Magnetfeldstärke und eine Magnetfeldrichtung. Ferner kann ein Parameter die Änderung des Magnetfeldes in seiner Richtung und/oder Stärke sein, wobei insbesondere eine erste Ableitung zumindest eines der Parameter bezüglich der Zeit vorgegeben ist.

Bei dem Ausführungsbeispiel umfassen die Spulen 4, 5, 6 supraleitende Materialien. Hierdurch ergibt sich der Vorteil, dass die Spulen 4, 5, 6, wenn sie bis unter die Sprungtemperatur der jeweils verwendeten Supraleiter-Materialien gekühlt sind, einen Strom praktisch ohne elektrischen Widerstand zu leiten vermögen und daher mit sehr hohen Stromstärken beaufschlagt werden können, ohne dass dies durch ohmsche Heizung zu einer wesentlichen Erhitzung und gegebenenfalls zu einer Beschädigung der Spulen 4, 5, 6 führt.

Bei dem Ausführungsbeispiel sind zwei Paare von Spulen 4, 5 außen an dem Tieftemperatur-Schild 10 angebracht und thermisch mit diesem verbunden. Sie werden daher bei dem Ausführungsbeispiel auf eine Temperatur von etwa 50 K gekühlt. Die Spulenpaare bestehen aus je zwei Spulen 4, 5, die in einer Helmholtz-Konfiguration gegenüber zueinander so angeordnet sind, dass sich die Probe 8 im Bereich ihrer gemeinsamen Achse befindet. Die Achsen der Paare von Spulen 4, 5, die am Tieftemperatur-Schild 10 angebracht sind, stehen senkrecht aufeinander und sind in einer Ebene parallel zur Ebene des optischen Tischs angeordnet, auf dem das System aufgebaut ist. Nachfolgend wird davon ausgegangen, dass die Achsen entlang einer x- beziehungsweise y-Achse verlaufen. Die Spulen 4, 5 erreichen durch die thermische Kopplung mit dem Tieftemperatur-Schild 10 eine Temperatur von etwa 50 K; als supraleitende Materialien der Spulen 4, 5 sind hier Hochtemperatur- Supraleiter vorgesehen, deren Sprungtemperatur hier bereits unterschritten ist und die daher im supraleitenden Zustand verwendet werden können.

Bei der in Figur 2 gezeigten Seitenansicht ist im Wesentlichen die 50 K-Stufe von außen gezeigt, wobei rechts und links die Spulen 4 gezeigt sind, während die Ansicht direkt auf den Querschnitt einer senkrecht dazu angeordneten Spule 5 gerichtet ist. Der Querschnitt der Spule 5 ist so gebildet, dass er um einen der in der 50 K-Stufe ausgebildeten optischen Zugang 14d verläuft, durch den gegebenenfalls die Probe 8 auf dem Probenhalter 9 im Inneren der 50 K-Stufe sichtbar ist.

Bei dem Ausführungsbeispiel ist ferner vorgesehen, dass ein weiteres Paar von Spulen 6 innen an dem Tieftemperatur-Schild 10 angebracht ist. Die Spulenachsen liegen auch hier übereinander und verlaufen senkrecht zu der oben beschriebenen x-y-Ebene; diese Richtung wird nachfolgend als "z-Achse" verstanden. Es wird eine Helmholtz-Konfiguration erreicht, mittels derer ein im Wesentlichen homogenes Magnetfeld entlang der z-Achse im Bereich der Probe 8 erzeugt wird. Auch hier wird durch den thermischen Kontakt zum Tieftemperatur-Schild 10 eine Kühlung auf 50 K erreicht und es ist ein Hochtemperatur-Supraleiter als stromführendes Material der Spulen 6 vorgesehen, dessen Sprungtemperatur hier bereits unterschritten ist. Auch die Spulen 6 werden also im supraleitenden Zustand betrieben.

Bei einem weiteren Ausführungsbeispiel kann das Magnetelement 6, insbesondere umfassend die Spulen 6, in thermischem Kontakt mit der 4 K-Stufe 11 stehen, in das Modul der 4 K-Stufe 11 integriert sein oder auf andere Weise angeordnet und/oder thermisch kontaktiert sein.

Insbesondere sind sowohl das Objektiv-Element 9, als auch das Magnetelement 6 zum Erzeugen eines Magnetfeldes in z-Richtung mit der 4 K-Stufe 11 thermisch kontaktiert beziehungsweise in die 4 K-Stufe 11 integriert.

Bei weiteren Ausführungsbeispielen können Magnetelemente 4, 5, 6 in unterschiedlichen Konfigurationen und Kombinationen mit den verschiedenen Modulen und Stufen 10, 11, 13 des Systems thermisch und/oder mechanisch gekoppelt sein. Insbesondere sind Magnetelemente 4, 5, 6 mit Halbleitermaterialien thermisch so mit der 50 K-Stufe 10 oder mit der 4 K-Stufe 11 gekoppelt, dass die jeweils nötigen Temperaturen zum Unterschreiten der Sprungtemperatur erreicht werden und die entsprechenden Magnetelemente 4, 5, 6 ihren supraleitenden Zustand einnehmen. Ferner können Magnetelemente außerhalb der 300 K- Stufe 13 angeordnet sein.

Bei weiteren Ausführungsbeispielen können anders ausgebildete elektromagnetische Elemente 4, 5, 6 vorgesehen sein. Beispielsweise können andere als Spulen-Konfigurationen verwendet werden, es können andere Anordnungen von Spulen und es können verschiedene Materialien verwendet werden. Die elektromagnetischen Elemente 4, 5, 6 können ferner in verschiedenen Bereichen angeordnet und thermisch kontaktiert sein: Beispielsweise kann zumindest ein elektromagnetisches Element thermisch mit der 4 K-Stufe 11 kontaktiert sein; in diesem Fall können insbesondere supraleitende Materialien verwendet werden, die eine sehr niedrige Sprungtemperatur aufweisen. Ferner kann zumindest ein elektromagnetisches Element im Bereich der Umgebungstemperatur angeordnet sein, beispielsweise thermisch kontaktiert mit der 300 K-Stufe 13, wobei insbesondere nichtsupraleitende Materialien verwendet werden.

Bei weiteren Ausführungsbeispielen kann zumindest ein elektromagnetisches Element ein nicht-supraleitendes Material umfassen, etwa Kupfer. In diesem Fall, etwa bei einer thermischen Kontaktierung mit der 50 K-Stufe, kann die Kühlung der 50 K-Stufe genutzt werden, um die durch elektrischen Widerstand entstehende Wärme effizient abzuführen, sodass auch hier ein relativ hoher Strom verwendet werden kann, um ein hohes Magnetfeld erzeugen zu können.

Bei weiteren Ausführungsbeispielen kann vorgesehen sein, dass der Tieftemperatur-Schild 10 vakuumdicht gegenüber der 300 K-Stufe 13 beziehungsweise der Vakuumglocke ausgestalten ist. Die 300 K-Stufe 13 und der Tieftemperatur-Schild 10 begrenzen dabei verschiedene Volumen, in denen beispielsweise verschiedene Druckbedingungen hergestellt werden können und in denen gegebenenfalls verschiedene Gase und Gasgemische präsent sein können.

So kann etwa vorgesehen sein, dass in den vom Tieftemperatur-Schild umschlossenen Raum ein Austauschgas bei einem definierten Druck eingebracht wird, etwa Helium. Hierdurch kann beispielsweise eine besonders homogene Temperaturverteilung zwischen der ersten Kontaktfläche 1, dem Probenhalter 7 und der Probe 8 erreicht werden. Das Austauschgas verhindert dabei insbesondere das Auftreten eines Temperaturgradienten zwischen den genannten Komponenten, die im thermischen Kontakt zur ersten Kontaktfläche 1 stehen.

Darüber hinaus kann das Austauschgas die Qualität von Messungen verbessern, die beispielsweise durch das Objektiv-Element 9 vorgenommen werden, und es kann eine mögliche statische Aufladung der Probe 8 verringern oder unterbinden. Weiter kann durch eine vakuumtaugliche Ausgestaltung des Tieftemperatur-Schildes ein lokaler Druck an der Probe 8 nochmals verringert werden, wodurch ein Ultrahochvakuum innerhalb des Tieftemperatur-Schildes ermöglicht wird. Die vakuumdichte Abdichtung des Tieftemperatur-Schildes 10 kann hierbei insbesondere dazu dienen, die Bedingungen zum Erreichen eines besonders niedrigen Drucks zusätzlich zu verbessern.

Bei weiteren Ausführungsbeispielen können verschiedene Kombinationen von Druck beziehungsweise Vakuum, und Gas in den durch die Vakuumglocke der 300 K-Stufe 13 und durch den Tieftemperatur-Schild 10 definierten Bereichen vorgesehen sein.

Bei einem weiteren Ausführungsbeispiel ist das System in einen optischen Tisch integriert. Dieser weist eine Tischplatte mit einer Ausnehmung auf, die beispielsweise rund oder in einer anderen Form so ausgebildet sein kann, dass die 300 K-Stufe als eine Vakuumglocke an der Tischplatte befestigt werden kann. Beispielsweise kann zur Befestigung die Basis 3 verwendet werden, die etwa mittels Schrauben an der Tischplatte fixierbar ist. Auch für die Module 10, 11 der 50 K-Stufe 10 beziehungsweise der 4 K-Stufe 11 können Befestigungsmöglichkeiten in dem Tisch integriert sein.

Der Tisch umfasst bei dem Ausführungsbeispiel ferner die erste 1 und zweite Kontaktfläche 2, wobei diese mit einer Kältemaschine verbunden sind, die wiederum fest oder lösbar mit dem optischen Tisch verbunden ist. Insbesondere ist dabei eine vibrationsdämpfende Verbindung zwischen dem Tisch und der Kältemaschine vorgesehen.

Bei weiteren Ausführungsbeispielen kann eine dritte Kontaktfläche im System vorgesehen sein, die wiederum mit zumindest einem weiteren Magnetelement in thermischen Kontakt steht. Des Weiteren ist prinzipiell die Anzahl der Kontaktflächen und der damit in thermischen Kontakt stehenden Magnetelemente nicht begrenzt.

### Bezugszeichenliste

- 1: Erste Kontaktfläche
- 2: Zweite Kontaktfläche
- 3: Basis
- 4: Magnetelement, Elektromagnetisches Element, Spule (x-Richtung)
- 5: Magnetelement, Elektromagnetisches Element, Spule (y-Richtung)
- 6: Magnetelement, Elektromagnetisches Element, Spule (z-Richtung)
- 7: Probenhalter
- 8: Probe
- 9: Objektiv-Element
- 10: Modul, Tieftemperatur-Schild, 50 K-Stufe
- 11: Modul, 4 K-Stufe
- 12a, 12b, 12c: Optischer Zugang (300 K-Stufe)
- 13: Modul, 300 K-Stufe
- 14a, 14b, 14c, 14d: Optischer Zugang (50 K-Stufe)

## Patentansprüche

1. System zum Bereitstellen eines Magnetfelds für eine Probe (8), umfassend
eine erste Kontaktfläche (1) zum thermischen Kontaktieren der Probe (8); und
eine zweite Kontaktfläche (2), die mit zumindest einem Magnetelement (4, 5,) in thermischem Kontakt steht.

2. System gemäß Anspruch 1,
**dadurch gekennzeichnet, dass**
das zumindest eine Magnetelement (4, 5) an einem Tieftemperatur-Schild (10) befestigt ist; wobei
der Tieftemperatur-Schild (10) mit der zweiten Kontaktfläche (2) in thermischem Kontakt steht.

3. System gemäß einem der vorhergehenden Ansprüche,
**gekennzeichnet durch**
zumindest eine dritte Kontaktfläche, die mit zumindest einem weiteren Magnetelement in thermischem Kontakt steht.

4. System gemäß einem der vorhergehenden Ansprüche,
**dadurch gekennzeichnet, dass**
das Magnetelement (4, 5) mit einer Steuereinheit gekoppelt ist, wobei
die Steuereinheit dazu eingerichtet ist, das Magnetelement (4, 5) in Abhängigkeit von einem vorbestimmten Magnetfeld-Parameter mit einem Stromfluss so zu beaufschlagen, dass das bei der Probe (8) bereitgestellte Magnetfeld den vorbestimmten Magnetfeld-Parameter aufweist.

5. System gemäß einem der vorhergehenden Ansprüche,
**gekennzeichnet durch**
zumindest ein weiteres Magnetelement (4, 5), das ebenfalls mit der zweiten Kontaktfläche (2) in thermischem Kontakt steht und das paarweise mit dem Magnetelement (4, 5) angeordnet ist; wobei
die paarweise angeordneten Magnetelemente (4, 5) an gegenüberliegenden Seiten der Probe (8) so angeordnet sind, dass sie eine gemeinsame Achse eines durch sie erzeugbaren Magnetfeldes aufweisen.

6. System gemäß Anspruch 5,
**dadurch gekennzeichnet, dass**
zwei Paare von paarweise angeordneten Magnetelementen (4, 5) in thermischem Kontakt mit der zweiten Kontaktfläche (2) stehen und so angeordnet sind, dass die Achsen der mittels der jeweils paarweise zueinander angeordneten Magnetelementen (4, 5) erzeugbaren Magnetfelder senkrecht zueinander verlaufen.

7. System gemäß einem der vorhergehenden Ansprüche,
**dadurch gekennzeichnet, dass**
ferner zumindest ein weiteres Magnetelement (6) in thermischem Kontakt zu der ersten Kontaktfläche (1) steht.

8. System gemäß einem der vorhergehenden Ansprüche,
**dadurch gekennzeichnet, dass**
das Magnetelement (4, 5, 6) ein supraleitendes Material umfasst, insbesondere einen Hochtemperatursupraleiter.

9. System gemäß einem der vorhergehenden Ansprüche,
**dadurch gekennzeichnet, dass**
das Magnetelement (4, 5, 6) ein Metall oder Halbmetall umfasst.

10. System gemäß einem der Ansprüche 2 bis 9,
**dadurch gekennzeichnet, dass**
der Tieftemperatur-Schild (10) eine umlaufende Wand umfasst, welche die Probe (8) umgibt und welche mit zumindest einer optischen Zugangsöffnung (14a, 14b, 14c, 14d) versehen ist.

11. Tisch mit dem System gemäß einem der vorhergehenden Ansprüche, wobei die erste (1) und zweite Kontaktfläche (2) im Bereich einer Tischplatte des Tischs ausgebildet sind.
